# EUROPÄISCHE PATENTSCHRIFT

(11) **EP 1 088 116 B1**
(45) Veröffentlichungstag und Bekanntmachung des Hinweises auf die Patenterteilung: **29.01.2003**
(21) Anmeldenummer: 99931005.5
(22) Anmeldetag: 04.05.1999
(51) Int. Cl.: C23C 16/30, C23C 14/06, B05D 7/24

(54) **VERFAHREN ZUM AUFBRINGEN EINES SCHICHTSYSTEMS AUF OBERFLÄCHEN**
METHOD FOR APPLYING A COATING SYSTEM TO SURFACES
PROCEDE POUR APPLIQUER, UN SYSTEME DE COUCHE DE PROTECTION SUR DES SURFACES

(30) Priorität: 30.05.1998 DE 19824364
(43) Veröffentlichungstag der Anmeldung: 04.04.2001
(73) Patentinhaber: ROBERT BOSCH GMBH, 70442 Stuttgart (DE)
(72) Erfinder: RAUSCHNABEL, Johannes, D-70197 Stuttgart (DE); VOIGT, Johannes, D-71229 Leonberg (DE)
(86) Internationale Anmeldenummer: DE9901326
(87) Internationale Veröffentlichungsnummer: WO99063129

(56) Entgegenhaltungen:
- EP-A- 0 801 146
- US-A- 5 242 740
- DATABASE WPI Section Ch, Week 8152 Derwent Publications Ltd., London, GB; Class A10, AN 1981-95950d XP002120699 "FORMING HARD COATING OF ORGANIC-INORGANIC COMPLEXON PLASTIC BASE...." & JP 56 147829 A (ASAHI GLASS CO LTD), 17. November 1981 (1981-11-17)
- PATENT ABSTRACTS OF JAPAN vol. 1995, no. 04, 31. Mai 1995 (1995-05-31) & JP 07 016451 A (NIPPON SHEET GLASS CO LTD), 20. Januar 1995 (1995-01-20)
- FRACASSI F ET AL: "PLASMA-ASSISTED DEPOSITION OF TUNGSTEN-CONTAINING SILOXANE THIN FILMS" THIN SOLID FILMS, Bd. 264, Nr. 1, 1. August 1995 (1995-08-01), Seiten 40-45, XP000523146 ISSN: 0040-6090
- PATENT ABSTRACTS OF JAPAN vol. 010, no. 245 (C-368), 22. August 1986 (1986-08-22) & JP 61 073881 A (FUJI ELECTRIC CO LTD), 16. April 1986 (1986-04-16)
- PATENT ABSTRACTS OF JAPAN vol. 015, no. 327 (P-1240), 20. August 1991 (1991-08-20) & JP 03 120519 A (CANON INC), 22. Mai 1991 (1991-05-22)
- PATENT ABSTRACTS OF JAPAN vol. 014, no. 356 (C-0745), 2. August 1990 (1990-08-02) & JP 02 129375 A (FUJITSU LTD), 17. Mai 1990 (1990-05-17)
- PATENT ABSTRACTS OF JAPAN vol. 1995, no. 09, 31. Oktober 1995 (1995-10-31) & JP 07 153071 A (TDK CORP), 16. Juni 1995 (1995-06-16)

## Beschreibung

Die Erfindung betrifft ein Verfahren zum Aufbringen von Verschleißschutz-Mehrlagenschichten mit optischen Eigenschaften auf Oberflächen gemäß der Gattung des Hauptanspruchs.

### Stand der Technik

Es ist bekannt, mittels verschiedener Techniken, beispielsweise Laserpolymerisation, reaktives Sputtern oder Galvanisieren, Schichten auf Substrate aufzubringen. In der US-PS 4,830,873 ist beschrieben, dünne transparente Schichten auf die Oberfläche von optischen Elementen durch Plasmapolymerisation von Silizium-Ausgangsverbindungen aufzubringen. Die dabei entstandenen Polysiloxanschichten sind sehr hart und transparent. In der US-PS 4,619,865 ist ein Verfahren beschrieben, Verschleißschutzschichten, insbesondere Mehrlagenschutzschichten mittels Magnetronsputtern aufzubringen. Jede Schicht hat dabei unterschiedliche Härte- oder Abriebfestigkeit. In diesen Mehrlagenschichten können auch verschiedene Schichteigenschaften miteinander kombiniert werden, beispielsweise wirkt eine Schicht als Diffusionsbarriere für Wasserdampf, die zweite Schicht ist extrem hart und die dritte Schicht kann z.B. elektrisch isolierend sein.

Bislang ist es jedoch noch nicht befriedigend gelöst, andere Substrate als Stahl, Keramik oder Glas, insbesondere Kunststoffe, ausreichend verschleißresistent zu gestalten. Sollen beispielsweise Kunststoffe mechanisch belastet werden, so müssen beispielsweise Kunststofformteile mit Verschleißschutzbeschichtungen versehen werden. Es ist zu diesem Zweck bekannt, daß neben dem Aufbringen einer kratzfesten Schutzlackschicht auch mittels Plasmapolymerisation beispielsweise verschleißresistente Polysiloxanschichten aufgebracht werden können. Oftmals ist es jedoch aufgrund des verwendeten Substrates, beispielsweise Polycarbonat, nötig, die Verschleißschutzschicht mittels geeigneter Zusätze UV-resistent zu gestalten, damit sich die oberste Kunststoffschicht bei Freibewitterung nicht zersetzt und damit die Haftung der Verschleißschutzschicht verschlechtert. Um dies zu vermeiden, wird beispielsweise ein UV-Absorber im Lack gelöst, der nach Aushärtung des Lacks das Substrat vor Lichteinwirkung schützen soll. Lacke sind auf Dauer nicht verschleißbeständig.

Es bestand daher die Aufgabe, ein Verfahren zu entwickeln, welches ermöglicht, Einlagerungs- oder Mehrlagenschichten, die optische Eigenschaften, insbesondere UV-Eigenschaften, wie Beständigkeit und Absorption oder Reflexion der UV-Strahlung, besitzen, mit hoher Verschleißbeständigkeit auf Substraten, insbesondere Substraten, die bei Bewitterung degradieren können, wie beispielsweise Kunststoffbauteilen, zu kombinieren.

### Vorteile der Erfindung

Erfindungsgemäß wird ein Verfahren zum Aufbringen von Schutzschichten mit optischen Eigenschaften, insbesondere mit guten UV-Schutzfunktionen, auf Oberflächen mittels mindestens zweier unterschiedlicher Abscheideschritte eingesetzt. Der eine Schritt besteht in einem plasmagestützten CVD-Verfahren und der mindestens eine andere Schritt in einer Stoffabscheidung mittels PVD-Technik. Durch die Kombination dieser Verfahren in einem Vakuumrezipienten werden die Investitionskosten deutlich gesenkt. Durch einen gleichzeitigen Betrieb beider Abscheidungsprozesse können sich die Beschichtungszeiten weiter reduzieren, was eine zusätzliche Kostensenkung mit sich bringen kann. Die Abscheidung der Verschleißschutzschicht wird vorteilhafterweise mit Hilfe der Plasmapolymerisation realisiert. Dies ist ein Beschichtungsverfahren, bei dem eine verdampfbare chemische Verbindung, beispielsweise eine aliphatische - aromatische oder olefinische Kohlenwasserstoffverbindung, bevorzugt Methan, Ethan, Ethylen oder Acetylen, eingesetzt wird. Besonders bevorzugt ist es, eine siliziumorganische Verbindung, bestehend aus den Elementen Silizium, Kohlenstoff und Wasserstoff oder mit zusätzlichem Stickstoff und/oder Sauerstoff, darunter vorteilhafterweise Tetramethylsilan (TMS), Hexamethyldisilan (HMDS), Hexamethyldisilazan (HMDS(N)), Tetraorthosilicat (TEOS), Dimethyldiethoxysilan (DMDEOS), Methyltrimethoxysilan (MTMOS), Tetramethyldisiloxan (TMDS(O)), Divinyltetramethyldisiloxan (VSI2), ganz besonders vorteilhaft Hexamethyldisiloxan (HMDS(O)) einzusetzen. Diesen "Monomeren" - von denen sich viele auf klassisch chemischen Wegen nicht polymerisieren lassen - können weitere verdampfbare Zusatzstoffe zugemischt werden, z.B. metallorganische Verbindungen, wie Tetraethylorthotitanat (TEOT), Tetraisopropylorthotitanat (TIPOT) oder Tetrakisdimethylaminotitanat.

In einer anderen vorteilhaften Ausführung können auch halogenierte Zusatzstoffe wie Tetrafluormethan, Chloroform oder Freone eingesetzt werden. Das Monomer-/Zusatzstoff-Gemisch wird nun im Rezipienten einem elektrischen Feld ausgesetzt, das ein Plasma des Dampfes zu zünden vermag. Hierbei werden die Dampfmoleküle aktiviert und fragmentiert in Ionen und Radikale. Diese hochreaktiven Fragmente kondensieren sich auf der Substratoberfläche und setzen sich zu einem neuen, sehr dichten Monomernetzwerk zusammen. Um die Isolierung der für das elektrische Feld notwendigen Elektroden mit isolierenden Schichten zu verhindern, was besonders bei der Verwendung siliziumhaltiger Dämpfe auftreten kann, empfiehlt sich die Speisung des Plasmas mit elektrischen Hochfrequenzfeldern in einem Frequenzbereich zwischen 50 KHz und 2,45 GHz, bevorzugt zwischen 400 KHz und 2,45 GHz. Wegen der höheren Abscheiderate ist es besonders vorteilhaft Radiofrequenz- (13,56 MHz) oder Mikrowelleneinstrahlung (2,45 GHz) einzusetzen. Mikrowellenplasmen können gepulst oder ungepulst mit oder ohne Magnetfeldunterstützung (ECR) betrieben werden. Die Pulsfrequenzen können zwischen wenigen Hertz und 10 KHz liegen, bevorzugt im Bereich zwischen 50 Hz und 2 KHz, wobei das Pulsdauer-zu Pausendauer-Verhältnis frei eingestellt werden kann.

In einer bevorzugten Ausführung kann bei einem Mikrowellenplasma durch räumliche Separierung des Plasmas vom Abscheidebereich die chemische Struktur und die Stöchiometrie der abgeschiedenen Schicht freier eingestellt werden, weil die Fragmentierung der Monomermoleküle schonender und besser steuerbar verläuft.
Dies kann in einer Ausführung durch die sogenannte "Remote-Anordnung" erzielt werden, bei der ein Edelgas und/oder ein nichtbeschichtendes Gas (sog. Reaktivgas, z.B. Sauerstoff, Stickstoff, Wasserstoff, Ammoniak, Lachgas, Halogen) in der Quelle und/oder in Quellennähe aktiviert und fragmentiert wird und durch eine entsprechend geführte Gasströmung in Richtung des Substrates gelangt. Dort erst trifft das aktivierte Reaktivgas auf das Monomergas, wodurch dieses seinerseits aktiviert und fragmentiert wird. Weiterer Vorteil dieser Anordnung ist die bessere Kontrolle der thermischen Belastung, vor allem bei mikrowellenabsorbierenden Materialien, wie z.B. Kunststoffen, da die Quelle, und damit der Ort der höchsten Plasmadichte, weiter vom Substrat entfernt ist.

In einer weiteren vorteilhaften Ausführung des Verfahrens lassen sich durch Substratbeheizung und/oder lonenbeschuß abgeschiedene Polymernetzwerke zusätzlich verdichten. Da die zusätzliche Beheizung bei temperaturempfindlichen Stoffen, insbesondere Kunststoffmaterialien, ihre Grenzen hat, ist ein Ionenbeschuss vorteilhaft, denn Verdichtung, d.h. Neuarrangement von Bindungen im Netzwerk in Richtung maximaler Bindungsabsättigung der am Netzwerk beteiligten Atome, kann mit vergleichsweise geringem Wärmeeintrag kombiniert werden. Insbesondere die Verwendung einer Vorspannung (Bias) am Substrat über eine hinter dem Substrat angebrachte Elektrode hat sich als sehr vorteilhaft erwiesen. Dadurch können Ionen direkt auf das Substrat gezogen werden. Hierbei können gepulste und ungepulste Bias-Spannungen eingesetzt werden. Im Falle des Pulsens sind Frequenzen zwischen 5 KHz und 27 MHz einsetzbar, insbesondere zwischen 10 KHz und 13,56 MHz. Bias-Spannungen können additiv zum PECVD-Prozeß, z.B. Mikrowellenplasmapolymerisation verwendet werden. Sie können in einer anderen Ausführung aber auch als einzige Quelle für die PECVD-Abscheidung der Verschleißschutzschicht eingesetzt werden. Hierbei haben sich besonders Hochfrequenz-Biasspannungen als vorteilhaft erwiesen, insbesondere solche mit Frequenzen im Bereich 50 KHz bis 800 KHz oder 13,56 MHz.

Besondere optische Eigenschaften, insbesondere UV-Schutz können auf drei Wegen realisiert werden: erstens durch ein Paket von dünnen Schichten mit unterschiedlichen Brechungsindizes, die UV-Licht zu reflektieren vermögen; zweitens durch eine Absorptionsschicht, in der das UV-Licht absorbiert und in andere Energieformen umgewandelt wird; und drittens durch Einlagerung von Atom-, bzw. Molekülverbunden, sog. Clustern, deren Größe und Konzentration in der Matrix so gewählt ist, daß UV-Strahlung mit diesen Clustern effektiv wechselwirken kann.
Die UV-Schutzfunktion kann durch Metallverbindungen und im Falle von Clustern auch durch reine Metalle realisiert werden. Diese können in die Verschleißschutzschicht als Partikel, Phasen oder Zwischenschichten, z.B. auch in Form von Multilagen-Schichtpaketen integriert werden. Dies wird mit Hilfe eines Zerstäubungsverfahrens (Sputtern) realisiert, bei dem vor die Kathode ein metallisches oder nichtmetallisches 'Target' geklemmt wird, von dem sukzessive durch in Richtung der Kathode beschleunigte Ionen oberflächlich Atome, Atomverbünde und Partikel verdampft, bzw. zerstäubt (gesputtert) werden. Dazu ist es möglich, DC-Magnetron-Sputtern, Pulsmagnetronsputtern, Doppelkathoden- oder Hochfrequenz- Sputtern einzusetzen.

Zur erfindungsgemäßen Integration der UV-Schutzfunktion ist beim Einsatz isolierender Targetmaterialien, z.B. Oxiden, der Einsatz einer bipolar gepulsten Doppelkathode besonders geeignet. Sehr vorteilhaft ist der Einsatz dieser Technik auch im Hinblick darauf, daß beim PECVD-Prozeß entstehende, dielektrische Verschleißschutzschichten auch auf die Kathodentargets abgeschieden werden können, um dort einen isolierenden Belag zu bilden, der die Zerstäubungsrate sukzessive bis auf Null zu drosseln vermag ("Vergiftung der Targets"). Beim Betrieb bipolar gepulster Doppelkathoden kann dieser Belag durch die wechselseitige Umpolung der Einzelkathoden wieder abgestäubt werden, wodurch eine nachhaltige Vergiftung der Targets verhindert wird.

In einer weiteren vorteilhaften Ausführung wird eine Hohlkathode verwendet. Deren Vorteil liegt darin, daß durch die kontinuierliche Gasströmung, die aus der Hohlkathode heraus geführt wird, eine Beschichtung der Targets, die innerhalb der Hohlkathode angebracht sind, nicht möglich ist.

In einer vorteilhaften Ausführung werden zum Sputtern der UV-Schutzschicht Oxide, Silizide, Carbide, Boride, Nitride, Sulfide, Fluoride, Selenide, Telluride der Elemente der vierten bis sechsten Nebengruppe sowie der Elemente La, Ce, Zn, In, Sn, Al, Si, Ge, Sb, Bi und/oder deren Mischungen verwendet. Dadurch können metallische, aber auch oxidische, silizidische, carbidische, boridische, nitridische, sulfidische, fluoridische, selenidische und/oder telluridische Einlagerungen in das Schichtsystem integriert werden.

Das Abscheiden des einzulagernden, optisch wirksamen Materials durch eine Magnetronsputtertechnik kann erfindungsgemäß entweder dadurch erfolgen, daß man Targets aus Elementen, z.B. Titan, Zink oder Silizium (s.o.), Legierungen, z.B. Al-Mg-Si oder Zr-Al, oder entsprechende Verbindungen, z.B. TiO, ZnS, SiO usw., mit Hilfe von Edelgasen, z.B. Argon, zerstäubt, die dann anschließend erst in der PECVD-Prozeßatmosphäre zu den Verbindungen gewünschter Stöchiometrie reagieren. Oder man zerstäubt bereits mit dem Gas, mit dem die chemische Reaktion stattfinden soll (dem "Reaktivgas"), wobei der Prozeß wegen Vergiftungsgefahr sehr genau kontrolliert werden muß, z.B. mit Hilfe des Plasmaemissionsmonitoring. Aber auch in dieser Ausführung kann eine definierte Nachreaktion in der Atmosphäre des PECVD-Prozesses gewünscht und eingestellt werden.
Zur Einstellung der Nachreaktion dienen Prozeßparameter wie das Verhältnis von Mittlerer Freier Weglänge der Partikel zwischen Stößen mit Reaktivgas oder Dampfmolekülen (durch den Prozeßdruck gegeben), eingekoppelte Leistung im PECVDund PVD-Prozeß oder Target-Substrat-Abstand.

Als Reaktivgase können nichtbeschichtende Gase wie z.B. Sauerstoff, Wasserstoff, Diboran, Stickstoff, Lachgas, Ammoniak, Stickstofftrifluorid, Schwefelwasserstoff und/oder Fluor eingesetzt werden. Beschichtende Gase, wie z.B. Kohlenwasserstoffe, bororganische Verbindungen, halogenierte Kohlenwasserstoffe können ebenfalls zur Nachreaktion eingesetzt werden, werden aber nicht als Zerstäubungs- und Reaktivgase verwendet, sondern als Monomere.

Um die chemische Zusammensetzung der Schicht genau einzustellen und die Vergiftung der Targets besser zu kontrollieren, wird in einer besonders vorteilhaften Ausführung direkt an den Kathoden das Gas eingeführt, mit dem die Targets zerstäubt werden sollen (das "Sputtergas"), während das Reaktivgas mit definiertem Abstand zu den Targets zugeführt wird. Dies ist in einfachster Weise durch getrennte Gaszuführungen (sog. Gasrähmen) realisiert.

Im Falle von einzulagernden Partikeln kann die Größe derselben über den Target-/Substrat-Abstand und den Gasdruck eingestellt werden.

Insbesondere ist es vorteilhaft, wenn das Verfahren so durchgeführt wird, daß die beiden Schritte gleichzeitig erfolgen. Dadurch entsteht mindestens eine Schicht mit den gewünschten optischen und Verschleißschutz-Eigenschaften, wobei der durch Sputtern aufgebrachte UV-Schutz homogen in der Verschleißschutzschicht eingelagert sein kann. Die Chemie der eingelagerten Moleküle, Partikel oder Lagen wird dabei durch Reaktionen mit dem Reaktivgas und/oder Molekülen, Fragmenten, Atomen des Monomerdampfes aus dem PECVD-Prozeß beeinflußt. Darüberhinaus sind Reaktionen in der abgeschiedenen Schicht vorhanden. Beispielsweise werden zerstäubte Atome, Cluster oder Partikel oxidationsempfindlicher Elemente oder Verbindungen wie z.B. Aluminium, spätestens bei der Einlagerung in eine Siloxan-Plasmapolymerschicht oxidiert. Ist noch eine ausreichende Konzentration an Monomerdampf im Prozeßgas vorhanden, so wird die Reaktion wie beschrieben schon vor dem Auftreffen auf die Schicht vonstatten gehen. Ein Kernbestandteil des erfindungsgemäßen Verfahrens ist genau diese gegenseitige chemische Beeinflussung von PECVDund PVD-Verfahren, die bei Gleichzeitigkeit der Prozesse besonders stark ausgeprägt ist.
Es ist möglich, das Verfahren in einer nicht unterteilten Einkammeranlage durchzuführen, wobei die reaktiven Bestandteile des Sputterprozesses wie oben beschrieben dann zum großen Teil aus dem Monomerdampf der Plasmapolymerisation stammen.

Es ist jedoch auch in vorteilhafter Weise möglich, durch mehrfach hintereinander durchgeführte Schritte: Reaktivsputtern, Plasmapolymerisation, Reaktivsputtern usw., die Zusammensetzung der durch Zerstäubung abgeschiedenen Schichtbestandteile genauer einzustellen, sofern während des Plasmapolymerprozesses die Kathodenshutter geschlossen sind, so daß sich die Kathodentargets nicht mit Plasmapolymer belegen können. Hierbei resultiert eine eher schichtartige Verteilung der Einlagerung in der Matrix.

In einer vorteilhaften Ausführung kann aber auch eine etwas weitergehende Trennung der Prozeßgasatmosphären dadurch erreicht werden, daß man zwischen PVD- und PECVD-Prozeß abpumpt, Edelgas einläßt, wieder abpumpt, und dann erst das Monomer einläßt.
Eine erfindungsgemäße Prozeß- und Anlagenvariante ist eine Vakuumkammer, die mit einer Kompartimentierung der Prozeßbereiche innerhalb der Vakuumkammer ohne Schleusentechnik, aber z.B. mit Blechblenden und entsprechender Frischgas- und Abgasströmungsführung ausgerüstet wird. Dadurch wird ebenfalls eine etwas stärkere Trennung der unterschiedlichen Prozesse erreicht, die eine gezielte Anpassung an die gewünschte Stöchiometrie der PVD-Abscheidung erlaubt.
Ein Mehrlagenschichtaufbau der Verschleißschutzmatrix kann in einer weiteren vorteilhaften Ausführung auch bewußt so gewählt werden, um extreme Verschleißfestigkeit mit guter Homogenität und ausgezeichneten UV-Schutzeigenschaften, beispielsweise Reflexion kritischer UV-Lichtwellenlängen an dem Mehrlagenpaket, zu erzielen.
Um Einfärbung zu vermeiden und den Reflexionsgrad zu maximieren, sind hierbei Schichten mit genau definierter Dicke, guter Dickenhomogenität und abwechselnd großen und kleinen Brechungsindizes nötig. Hierbei trägt die Matrix sowohl mit ihrer Härte zum Verschleißschutz, als auch mit ihrem Brechungsindex zum Interferenzschichtpaket bei.
In einer besonders vorteilhaften Ausführung wird bei weichen Substratmaterialien, wie z.B. Kunststoffen, eine weiche Matrixbasisschicht abgeschieden, die mit wachsender Schichtdicke kontinuierlich in ihrer Härte gesteigert wird. Darin werden die einzelnen Lagen des Reflektionsschichtpaketes eingelagert. Das Gesamtschichtpaket schließt nach oben mit einer extrem verschleißfesten Deckschicht ab.

Die Verschleißschutzmatrix kann in einer weiteren vorteilhaften Ausführung auch so abgeschieden werden, daß die Härte- und Elastizitätsanpassung an Substrat und Verschleißbelastung schrittweise erfolgt. Dies hat ein Multilagenschichtpaket zur Folge. Dabei wird das optische Funktionsmaterial sehr vorteilhaft ebenfalls in einzelnen Schichten abgeschieden.
Im Falle eines UV-Reflektionsschichtpaketes, das in eine Multilagen-Verschleißschutzmatrix integriert werden soll, ist es von besonderem Vorteil, wenn die einzelnen Verschleißschutzschichten nicht nur im Hinblick auf ihre Härte und Elastizität, sondern auch im Hinblick auf ihren Brechungsindex optimiert werden. Dadurch kann die Verschleißschutzmatrix optische Funktionalität im Rahmen des Interferenzschichtpaketes übernehmen.

In einer anderen Ausführung, bei der Partikel in die Matrix eingelagert werden, ist es möglich diese in einem Konzentrations-, Morphologie- und/oder Stöchiometriegradienten in die Matrix einzubinden. Dafür werden die Sputter- und/oder die Reaktivgasparameter während des PVD-Prozesses kontinuierlich verändert. Insbesondere in Kombination mit einem Härtegradienten der Verschleißschutzschicht können solche Partikeleinlagerungsgradienten vorteilhaft für optische Belange eingesetzt werden.

Die Dicke der Kombischicht und die Konzentration der optischen Funktionsmaterialien wird über die Dauer der Abscheideprozesse, den Druck, die Strömungsverhältnisse und die eingestrahlte Energie eingestellt.

### Zeichnung

Die Erfindung ist in den nachstehenden Zeichnungen und den Ausführungsbeispielen näher erläutert.

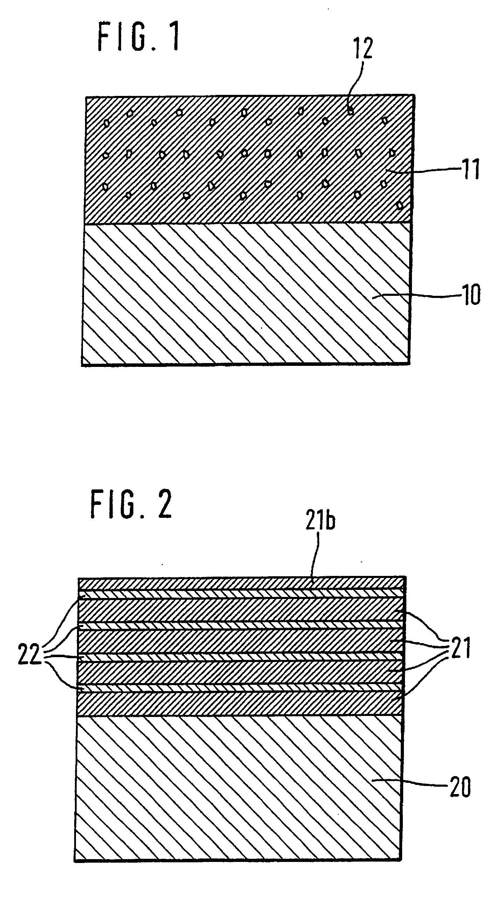

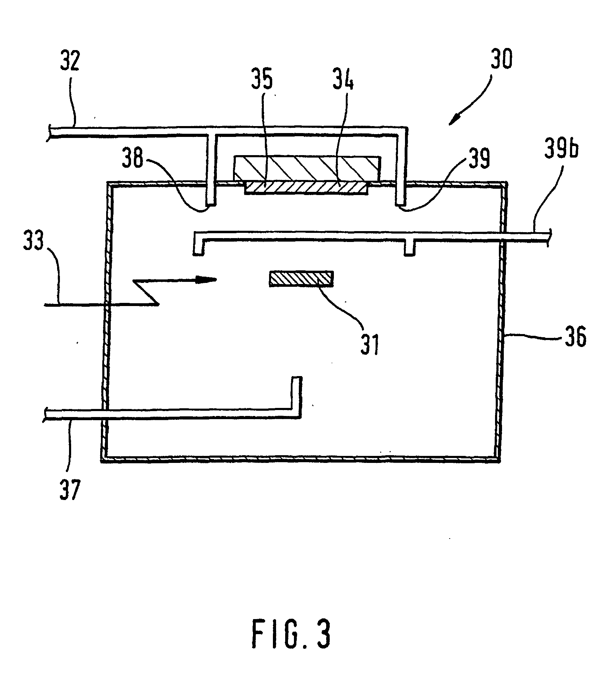

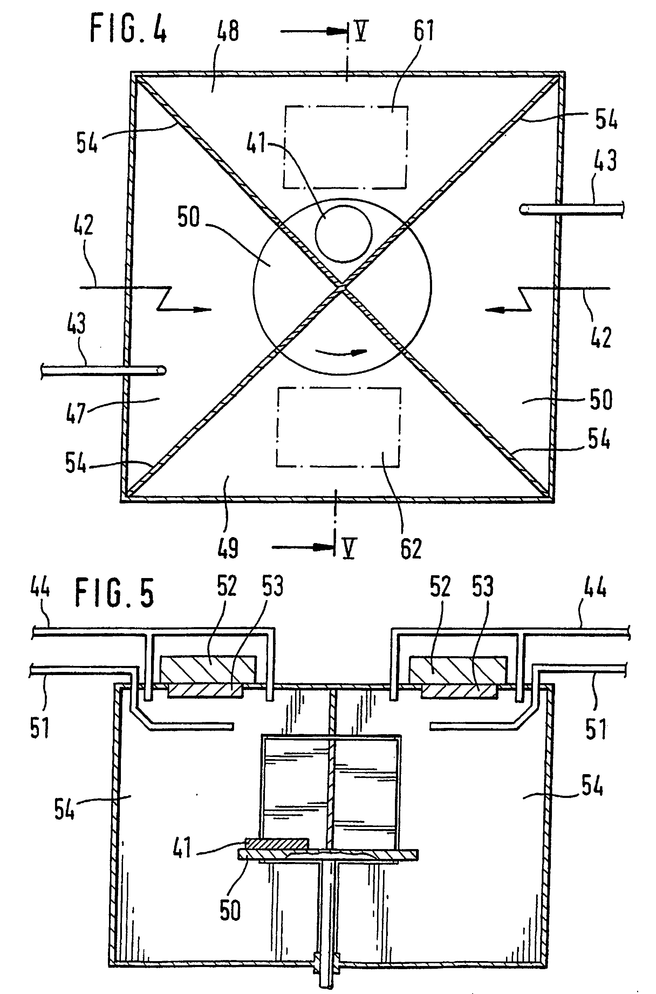

Figur 1 zeigt einen möglichen Schichtaufbau auf ein Substrat bei gleichzeitigem Betrieb von Sputter- und Mikrowellenquelle, Figur 2 zeigt einen Schichtaufbau bei abwechselndem Betrieb von Sputter und Mikrowellenquelle, Figur 3 zeigt eine Vorrichtung zur Durchführung des erfindungsgemäßen Verfahrens, Figur 4 zeigt eine Mehrkammervorrichtung zur Durchführung des erfindungsgemäßen Verfahrens und Figur 5 einen Schnitt durch die Vorrichtung gemäß Figur 4 nach der Linie V-V.

### Beschreibung der Ausführungsbeispiele

Figur 1 zeigt einen Schichtaufbau bei gleichzeitigem Betrieb von Sputter- und Mikrowellenquelle. Auf einem Substrat 10, beispielsweise bestehend aus Polycarbonat, PVC, Polyethylen oder einem anderen Kunststoff oder einem anderen Substrat, ist eine Schicht aufgebracht, die aus zwei Bestandteilen besteht. Der eine Bestandteil 11, der die Schichtmatrix ausmacht, ist eine Verschleißschutzschicht aus durch Plasmapolymerisation aufgebrachtem Polysiloxan. In diese Schicht 11 sind durch Zerstäuben, z.B. reaktives Doppelkathoden-Sputtern, Metallverbindungsteilchen 12 als UV-Schutz eingebracht, die beispielsweise aus Zinksulfid, Titandioxid, Cerdioxid oder dergleichen bestehen. Die Teilchen 12 sind homogen in der Verschleißschutzschicht 11 eingebracht.

Figur 2 zeigt den Schichtaufbau auf einem Substrat 20, ebenfalls beispielsweise bestehend aus Polycarbonat, Polyethylen etc. Auf der Schicht 21, bestehend aus einer durch Plasmapolymerisation aufgebrachten Polysiloxanschicht, sind abwechselnd Schichten 22 bestehend aus der gesputterten Metallverbindung und weitere Polysiloxanschichten 21 aufgebracht. Den Abschluß zum tribologischen Kontakt hin bildet eine verschleißfeste Deckschicht. Die Lagen 22 sind in die Matrixschicht eingelagert. Dieses Schichtpaket aus den abwechselnden Schichten 21 und 22, die vorteilhafterweise einen stark unterschiedlichen Brechungsindex aufweisen, ermöglicht, daß an diesem Mehrschichtenpaket eine Reflexion von kritischen Wellenlängen elektromagnetischer Strahlung durch Interferenz erfolgt.

Figur 3 zeigt eine Vorrichtung zur Durchführung des erfindungsgemäßen Verfahrens, wobei eine sogenannte Einkammeranlage mit getrennter Gaszuführung beschrieben ist. Die Vorrichtung 30 besteht aus einer Kammer 36, in der die Reaktion stattfindet. In dieser Kammer ist auf einem Träger, der nicht dargestellt ist, ein Substrat 31 angeordnet. Auf der einen Seite der Kammer 36 ist eine Zuführung 37 für das Siliziummonomergas angeordnet. Der Zuführung 37 für das Siliziummonomergas entgegengesetzt angeordnet ist die Zuführung 32 für das Sputtergas. Zwischen den beiden Öffnungen 38 und 39, die von der Zuführung 32 für das Sputtergas in die Reaktionskammer 36 weisen, ist eine Kathode 34, die mit einer nicht dargestellten Spannungsquelle verbunden ist, angeordnet, auf der wiederum das Target 35, bestehend aus der zu sputternden Verbindung, aufgebracht ist. Zusätzlich kann ein Reaktivgas über die Reaktivgaszuführung 39 b in die Kammer eingelassen werden. In der Nähe des Substrats ist ein Mikrowellengenerator 33 angebracht, der das Plasma erzeugt.

In Figur 4 und 5 ist eine weitere Vorrichtung zur Durchführung des erfindungsgemäßen Verfahrens dargestellt. Es handelt sich dabei um eine Mehrkammeranlage mit Kompartimentierung. Die Vorrichtung besteht aus vier durch Trennbleche 54 separierten Kammerbereichen 47, 48, 49 und 50. Im ersten und zweiten Reaktionsbereich 47, 50 ist jeweils eine PECVD-Quelle 42, z.B. eine Mikrowellenantenne mit dazugehöriger Stromversorgung zusammen mit jeweils einer Zuleitung 43 für das Siliziummonomer angebracht. Ein Substrat 41 ist in der Zeichnung im zweiten Kammerkompartiment 48 angeordnet. Im Kompartiment 48 und 49 findet das reaktive Sputtern statt, wobei im Kompartiment 48 eine erste Sputteranlage 61 und im Kompartiment 49 eine zweite Sputteranlage 62 angeordnet sind. Die Sputteranlagen 61, 62 verfügen jeweils über eine Kathode 52. Auf den Kathoden 52 ist je ein Target 53 aufgeklemmt. Die Gasversorgung der Kompartimente 47, 48 erfolgt durch jeweils eine Zuleitung 44 für das Sputtergas und jeweils eine Zuleitung 51 gegebenenfalls für ein Reaktivgas. Der Transport des Substrates 41 von Kompartiment zu Kompartiment erfolgt durch einen Drehtisch 60, der ebenfalls Trennbleche aufweist, um eine teilweise Trennung der Prozeßgasatmosphären in den einzelnen Kompartimenten 47, 48, 49, 50 zu gewährleisten. Nach erfolgter Beschichtung durch Sputtern wird das Substrat 41 in das erste Kompartiment 47 transferiert und dort mit dem zu beschichtenden Gas im Plasma in Verbindung gebracht. Nach jedem Reaktionsschritt wird das Substrat in die jeweils andere Kammer überführt, bis der gewünschte Mehrlagenaufbau auf dem Substrat erzielt wurde.

## Patentansprüche

1. Verfahren zum Aufbringen von mindestens einer Verschleißschutzschicht mit optischen Eigenschaften auf Oberflächen mittels mindestens zweier unterschiedlicher Abscheideschritte, wobei der eine Schritt ein plasmagestützter CVD-Prozeß zur Abscheidung einer Verschleißschutz-Matrix und der andere Schritt eine Stoffabscheidung mittels einer PVD-Technik zur Einlagerung optisch funktionalen Materials in die Matrix umfaßt, **dadurch gekennzeichnet, daß** am Substrat und/oder am Substrattisch zumindest zeitweise eine den Ionenbeschuss der abgeschiedenen Schicht erhöhende Vorspannung angelegt wird.

2. Verfahren nach Anspruch 1, **dadurch gekennzeichnet, daß** das aus dem PVD-Prozeß stammende Material chemisch vom PECVD-Prozeß und/oder der abgeschiedenen Matrix beeinflußt wird.

3. Verfahren nach Anspruch 1, **dadurch gekennzeichnet, daß** die beiden Schritte in einer Reaktionskammer durchgeführt werden.

4. Verfahren nach Anspruch 1 bis 3, **dadurch gekennzeichnet, daß** die plasmagestützte Stoffabscheidung eine Plasmapolymerisation ist.

5. Verfahren nach Anspruch 1 bis 4, **dadurch gekennzeichnet, daß** in dem Plasma monomere Kohlenwasserstoffverbindungen und/oder Siliziumverbindungen enthalten sind, ausgewählt aus der Gruppe bestehend aus aliphatischen - aromatischen oder olefinischen Kohlenwasserstoffverbindungen, bevorzugt Methan, Ethan, Ethylen oder Acetylen, siliziumorganische Verbindungen, bestehend aus den Elementen Silizium, Kohlenstoff und Wasserstoff oder mit zusätzlichem Stickstoff und/oder Sauerstoff, insbesondere Tetramethylsilan (TMS), Hexamethyldisilan (HMDS), Hexamethyldisilazan (HMDS(N)), Tetraorthosilicat (TEOS), Dimethyldiethoxysilan (DMDEOS), Methyltrimethoxysilan (MTMOS), Tetramethyldisiloxan (TMDS(O)), Divinyltetramethyldisiloxan (VSI2), ganz besonders vorteilhaft Hexamethyldisiloxan (HMDS(O)).

6. Verfahren nach einem der vorherigen Ansprüche, **dadurch gekennzeichnet, daß** die Verschleißschutzmatrix einen der zu einer graduellen Veränderung mechanischer Eigenschaften über die Schichtdicke führt.

7. Verfahren nach Anspruch 6, **dadurch gekennzeichnet, daß** der Schichtgradient ein Gradient der Stöchiometrie und/oder der Morphologie ist, der zu einer graduellen Veränderung mechanischer Eigenschaften über die Schichtdicke führt.

8. Verfahren nach Anspruch 6, **dadurch gekennzeichnet, daß** die chemische Variation der Prozeßgasatmosphäre durch Gasmischungsverhältnisse und/oder der elektrischen Parameter der eingestrahlten Energie, insbesondere der Leistung, über die Dauer des Prozesses eingestellt wird.

9. Verfahren nach Anspruch 6 und 7, **dadurch gekennzeichnet, daß** in der Verschleißschutzmatrix die Härte- und Elastizitätsanpassung zwischen Substrat und tribologischer Kontaktfläche (Deckschicht) schrittweise mit einem Multilagenschichtpaket erfolgt.

10. Verfahren nach Anspruch 1, **dadurch gekennzeichnet, daß** das Plasma durch Mikrowellen- und/oder Hochfrequenzanregung generiert wird.

11. Verfahren nach Anspruch 9, **dadurch gekennzeichnet, daß** eine Mikrowellenplasma-gestützte CVD-Abscheidung durch gepulste Mikrowelleneinstrahlung erzeugt wird.

12. Verfahren nach Anspruch 12, **dadurch gekennzeichnet, daß** die Vorspannung gepulst betrieben wird.

13. Verfahren nach Anspruch 1, **dadurch gekennzeichnet, daß** die Integration der optischen Funktion mittels einer PVD-Technik erfolgt.

14. Verfahren nach Anspruch 14, **dadurch gekennzeichnet, daß** die eingesetzte PVD-Technik ein Sputterverfahren ist.

15. Verfahren nach Anspruch 15, **dadurch gekennzeichnet, daß** das Sputtern durch eine Hohlkathodenquelle erfolgt.

16. Verfahren nach einem der vorherigen Ansprüche, **dadurch gekennzeichnet, daß** die abzuscheidenden Verbindungen, die die optische Funktion, insbesondere UV-Schutz, übernehmen, ausgewählt sind aus der Gruppe bestehend aus den Oxiden, Siliziden, Carbiden, Boriden, Nitriden, Sulfiden, Fluoriden, Seleniden, Telluriden der Elemente der vierten bis sechsten Nebengruppe, der Elemente La, Ce, Zn, In, Sn, Al, Si, Ge, Sb, Bi und/oder deren Mischungen.

17. Verfahren nach Anspruch 17, **dadurch gekennzeichnet, daß** das Sputtern von einem Target erfolgt, welches mindestens einen Bestandteil der aufzubringenden Verbindung enthält.

18. Verfahren nach Anspruch 18, **dadurch gekennzeichnet, daß** zum Zerstäuben des Targets ein Edelgasplasma, ein Sauerstoff- oder Stickstoffplasma gezündet wird oder ein Plasma, das aus einer Mischung von Edelgas und Reaktivgas besteht.

19. Verfahren nach Anspruch 19, **dadurch gekennzeichnet, daß** das zerstäubte Material in einem Reaktivgasplasma und dem Monomerplasma zur gewünschten Stöchiometrie nachreagiert.

20. Verfahren nach einem der vorhergehenden Ansprüche, **dadurch gekennzeichnet, daß** der PECVD- und der PVD-Prozeß gleichzeitig erfolgen.

21. Verfahren nach einem der vorherigen Ansprüche, **dadurch gekennzeichnet, daß** die beiden Prozesse zumindest einmal aufeinanderfolgen und sich eine Mehrlagen- oder Multilagenschicht bildet.

22. Verfahren nach einem der vorherigen Ansprüche, **dadurch gekennzeichnet, daß** der PVD-Prozeß so geführt wird, daß in der Matrix ein Gradient der Konzentration, der Stöchiometrie und/oder der Morphologie des eingelagerten Materials ausgebildet wird.

23. Verfahren nach einem der vorhergehenden Ansprüche, **dadurch gekennzeichnet, daß** wenigstens eine aufgebrachte Schicht auf elektromagnetische Strahlung im ultravioletten Bereich des Spektrums Absorptionseigenschaften aufweist.

24. Verfahren nach einem der vorherigen Ansprüche, **dadurch gekennzeichnet, daß** die aufgebrachten Schichten unterschiedliche Brechnungsindizes besitzen, die zur Reflektion der elektromagnetischen Strahlung im ultravioletten Bereich des Spektrums führen.

## Claims

1. Method for applying at least one wear-resistant coating with optical properties to surfaces by means of at least two different deposition steps, one step comprising a plasma-enhanced CVD process for depositing a wear-resistant matrix and the other step comprising deposition of material by means of a PVD technique in order to incorporate optically functional material in the matrix, **characterized in that** at least from time to time a bias voltage which increases the ion bombardment of the deposited coating is applied to the substrate and/or to the substrate table.

2. Method according to Claim 1, **characterized in that** the material which originates from the PVD process is chemically influenced by the PECVD process and/or the deposited matrix.

3. Method according to Claim 1, **characterized in that** the two steps are carried out in a reaction chamber.

4. Method according to Claims 1 to 3, **characterized in that** the plasma-enhanced deposition of material is a plasma polymerization.

5. Method according to Claims 1 to 4, **characterized in that** the plasma contains monomeric hydrocarbon compounds and/or silicon compounds selected from the group consisting of aliphatic-aromatic or olefinic hydrocarbon compounds, preferably methane, ethane, ethylene or acetylene, organosilicon compounds, consisting of the elements silicon, carbon and hydrogen or with additional nitrogen and/or oxygen, in particular tetramethylsilane (TMS), hexamethyldisilane (HMDS), hexamethyldisilazane (HMDS (N)), tetraethyl orthosilicate (TEOS), dimethyldiethoxysilane (DMDEOS), methyltrimethoxysilane (MTMOS), tetramethyldisiloxane (TMDS (O)), divinyltetramethyldisiloxane (VSI2), and very particularly advantageously hexamethyldisiloxane (HMDS (O)).

6. Method according to one of the preceding claims, **characterized in that** the wear-resistant matrix leads to a gradual change in mechanical properties over the coating thickness.

7. Method according to Claim 6, **characterized in that** the coating gradient is a gradient of stoichiometry and/or morphology which leads to a gradual change in mechanical properties over the coating thickness.

8. Method according to Claim 6, **characterized in that** the chemical variation in the process-gas atmosphere is set by means of gas mixing ratios and/or the electrical parameters of the energy which is radiated in, in particular the power, over the duration of the process.

9. Method according to Claims 6 and 7, **characterized in that** in the wear-resistant matrix the hardness and elasticity matching between substrate and tribological contact surface (covering layer) takes place in steps using a multilayer coating assembly.

10. Method according to Claim 1, **characterized in that** the plasma is generated by microwave and/or highfrequency excitation.

11. Method according to Claim 9, **characterized in that** a microwave plasma-enhanced CVD deposition is produced by pulsed microwave radiation.

12. Method according to Claim 1, **characterized in that** the bias voltage is operated in pulsed mode.

13. Method according to Claim 1, **characterized in that** the integration of the optical function takes place by means of a PVD technique.

14. Method according to Claim 13, **characterized in that** the PVD technique used is a sputtering method.

15. Method according to Claim 14, **characterized in that** the sputtering takes place by means of a hollow cathode source.

16. Method according to one of the preceding claims, **characterized in that** the compounds which are to be deposited and are responsible for the optical function, in particular UV protection, are selected from the group consisting of the oxides, silicides, carbides, borides, nitrides, sulphides, fluorides, selenides, tellurides of the elements from the fourth to sixth subgroup, the elements La, Ce, Zn, In, Sn, Al, Si, Ge, Sb, Bi and/or mixtures thereof.

17. Method according to Claim 16, **characterized in that** the sputtering takes place from a target which contains at least one constituent of the compound which is to be applied.

18. Method according to Claim 17, **characterized in that** in order to atomize the target a noble-gas plasma, an oxygen plasma or a nitrogen plasma or a plasma which consists of a mixture of noble gas and reactive gas is ignited.

19. Method according to Claim 18, **characterized in that** the atomized material reacts further in a reactive gas plasma and the monomer plasma to produce the desired stoichiometry.

20. Method according to one of the preceding claims, **characterized in that** the PECVD process and the PVD process take place simultaneously.

21. Method according to one of the preceding claims, **characterized in that** the two processes follow one another at least once and a multilayer coating is formed.

22. Method according to one of the preceding claims, **characterized in that** the PVD process is conducted in such a way that a gradient of the concentration, the stoichiometry and/or the morphology of the incorporated material is formed in the matrix.

23. Method according to one of the preceding claims, **characterized in that** at least one applied coating has absorption properties for electromagnetic radiation in the ultraviolet region of the spectrum.

24. Method according to one of the preceding claims, **characterized in that** the applied coatings have different refractive indices, which lead to the reflection of the electromagnetic radiation in the ultraviolet region of the spectrum.

## Revendications

1. Procédé pour appliquer au moins une couche anti-usure dotée de propriétés optiques sur des surfaces en au moins deux étapes différentes de dépôt, la première utilisant un procédé CVD assisté par plasma pour déposer une matrice anti-usure tandis que la seconde étape comprend un dépôt, de matière effectué par une technique PVD pour insérer un matériau à fonctions optiques dans la matrice
**caractérise en ce que**
sur le substrat et/ou sur une table de substrat on applique au moins par instants une tension augmentant le bombardement ionique de la couche déposée.

2. Procédé selon la revendication 1.
**caractérisé en ce que**
le matériau apporté par le procédé PVD est influencé chimiquement par le procédé PECVD et/ou la matrice déposée.

3. Procédé selon la revendication 1,
**caractérisé en ce que**
les deux étapes sont effectuées dans une chambre de réaction,

4. Procédé selon les revendications 1 à 3,
le dépôt de matière assisté par plasma est une plasmapolymérisation.

5. Procédé selon les revendications 1 à 4,
**caractérisé en ce que**
le plasma contient des composés monomères d'hydrocarbure et/ou des composés de silicium, sélectionnés dans le groupe des hydrocarbures aliphatiques, aromatiques ou oléfiniques, de préférence du méthane, de l'éthane, de l'éthylène ou de l'acétylène, des composés organiques du silicium, contenant du silicium, du carbone, de l'hydrogène ou avec en plus de l'azote et/ou de l'oxygène, notamment la tetraméthylsilane (TMS), l'hexaméthyldisilane (HMDS), l'hexaméthyldisilazane (HMDS (N)), le tétraorthosilicate (TEOS), le diméthyldiethoxysilane (DMDEOS). le méthyltrimethoxysilane (MTMOS), le tetraméthyldisiloxane (TMDS (O)), le divinyltetramethyldisiloxane (VS 12), et le tout particulièrement avantageusement le hexaméthyldisiloxane (HMDS(O)).

6. Procédé selon l'une des revendications précédentes,
**caractérisé en ce que**
la matrice anti-usure, par l'intermédiaire de l'épaisseur des couches conduit à une variation graduelle des propriétés mécaniques.

7. Procédé selon la revendication 6,
**caractérisé en ce que**
le gradient de couche est un gradient de stoechiométrie et/ou de morphologie qui conduit à une modification graduelle des propriétés mécaniques par l'intermédiaire de l'épaisseur de couche.

8. Procédé selon la revendication 6,
**caractérisé en ce que**
la variation chimique de l'atmosphère du gaz de process, par les proportions du mélange de gaz et/ou les paramètres électriques de l'énergie irradiée, en particulier la puissance, a lieu pendant la durée du process.

9. Procédé selon les revendications 6 et 7,
**caractérisé en ce que**
dans la matrice anti-usure, l'adaptation de la dureté et de l'élasticité entre le substrat et le surface tribologique de contact (couche de couverture) s'effectue pas à pas avec un paquet multicouches.

10. Procédé selon la revendication 1,
**caractérisé en ce que**
le plasma est généré par une excitation à hyperfréquence et/ou à haute fréquence.

11. Procédé selon la revendication 9,
**caractérisé en ce que**
un dépôt CVD assisté par un plasma à hyperfréquence est obtenu par une irradiation à hyperfréquence, pulsée.

12. Procédé selon la revendication 10,
**caractérisé en ce que**
la tension de polarisation est pulsée.

13. Procédé selon la revendication 1.
**caractérisé en ce que**
l'intégration de la fonction optique est effectuée par une technique PVD.

14. Procédé selon la revendication 13,
**caractérisé en ce que**
la technique PVD utilisée est un procédé de pulvérisation.

15. Procédé selon la revendication 14,
**caractérisé en ce que**
la pulvérisation est assurée par une source à cathode creuse

16. Procédé selon l'une des revendications précédentes,
**caractérisé en ce que**
les composés à déposer, qui assurent la fonction optique, en particulier la protection contre les UV sont choisis dans le groupe composé des oxydes, des siliciures, des carbures, des borures, des nitrures, de sulfures, des fluorures, des séléniures, des tellurures des éléments du quatrième au sixième groupe, les éléments, La, Ce, Zn, In, Sn, Al, Si, Ge, Sb, Bi, et/ou avec mélanges de ces éléments.

17. Procédé selon la revendication 16,
**caractérisé en ce que**
la vaporisation est produite à partir d'une cible, qui contient au moins un constituant du composé à appliquer.

18. Procédé selon la rev. 17,
**caractérisé en ce que**
pour pulvériser la cible, on déclenche un plasma de gaz rare, un plasma d'oxygène ou un plasma d'azote ou un plasma composé d'un mélange de gaz rare et de gaz réactif.

19. Procédé selon la revendication 18,
**caractérisé en ce que**
le matériau pulvérisé réagit ensuite dans un plasma de gaz réactif et dans le plasma monomère à la stoechiométrie désirée.

20. Procédé selon l'une des revendications précédentes,
**caractérisé en ce que**
les process PECVD et PVD, se déroulent simultanément.

21. Procédé selon l'une des revendications précédentes,
**caractérisé en ce que**
les deux process se succèdent au moins une fois et il se forme une couche multistratifiée.

22. Procédé selon l'une des revendications précédentes,
**caractérisé en ce que**
le process PVD est conduit de manière qu'il se forme dans la matrice un gradient de concentration, de stoechiométrie et/ou de morphologie de matériau déposé.

23. Procédé selon l'une des revendications précédentes.
**caractérisé en ce qu'**
au moins une couche déposée présente des propriétés d'absorption du rayonnement électromagnétique dans la zone de l'ultraviolet du spectre.

24. Procédé selon l'une des revendications précédentes,
**caractérisé en ce que**
les couches déposées possèdent des indices de réfractions différents qui conduisent à la réflexion du rayonnement électromagnétique dans la zone de l'ultraviolet du spectre.
